# EUROPEAN PATENT SPECIFICATION

(11) **EP 2 862 667 B1**
(45) Date of publication and mention of the grant of the patent: **01.08.2018**
(21) Application number: 13804256.9
(22) Date of filing: 10.06.2013
(51) Int. Cl.: B23K 35/36, B23K 35/362, B23K 35/02, H05K 3/34

(54) **FLUX COMPOSITION, LIQUID FLUX, RESIN FLUX CORED SOLDER, AND SOLDER PASTE**
FLUSSMITTELZUSAMMENSETZUNG, FLÜSSIGES FLUSSMITTEL, LÖTMITTEL MIT EINEM HARZFLUSSMITTELKERN UND LÖTPASTE
COMPOSITION DE FLUX, FLUX LIQUIDE, FIL D'APPORT FOURRÉ POUR BRASAGE TENDRE À RÉSINOSE ET PÂTE À BRASER

(30) Priority: 11.06.2012 JP 2012132095
(43) Date of publication of application: 22.04.2015
(73) Proprietor: Senju Metal Industry Co., Ltd, Tokyo 120-8555 (JP)
(72) Inventor: HAGIWARA, Takashi, Tokyo 120-8555 (JP); YAMASAKI, Hiroyuki, Tokyo 120-8555 (JP)
(74) Representative: D Young & Co LLP
(86) International application number: PCT/JP2013/065954
(87) International publication number: WO 2013/187363

(56) References cited:
- EP-A1- 1 995 016
- DE-A1- 10 114 191
- JP-A- S4 978 655
- JP-A- S6 064 793
- US-A1- 2001 019 075
- US-A1- 2003 221 748
- US-A1- 2005 217 757
- US-A1- 2009 308 496

## Description

### [TECHNICAL FIELD]

The present invention relates to flux composition which removes any metal oxide existing on solder and a surface of metal to be soldered. Particularly, it relates to the flux composition that is capable of removing an oxide film of aluminum as the metal to be soldered, liquid flux obtained by solving this flux composition by a solvent, resin flux cored solder wire in which flux composed of the flux composition is included in solder, and solder paste in which a thixotropic agent, a solvent and solder powder are added to the flux composition.

### [BACKGROUND]

In general, the flux used for the soldering has an effect of removing any metal oxide existing on the solder and the surface of metal to be soldered at a solder melting temperature and an effect of enabling metallic elements to be transferred at a boundary therebetween.

In recent years, trace by aluminum (Al) or an aluminum alloy has been proposed instead of trace by copper (Cu). It has been known that in the soldering to aluminum, it is difficult to remove an oxide film formed on a surface of aluminum and the flux having enhanced activity has been used.

When, however, the flux has too enhanced activity, it corrodes base metal so that reliability cannot be maintained after the soldering. Further, the flux composition includes any components which cannot be decomposed and volatilized at a heating temperature at the soldering time and they remain as flux residue around the soldered portion after the soldering. In the flux having enhanced activity, water-soluble base materials have been often used and when the flux residue has water-soluble component, in a soldered product such as electronic parts and a board, there is a risk such that the corrosion facilitates in the soldered portion and the like because of moisture absorption into the flux residue. Therefore, it is necessary to wash the flux residue when components composing the flux residue are water-soluble.

On the other hand, when the flux has less activity, it is insufficient to remove the oxide film so that wettability thereof deteriorates and soldability thereof also deteriorates.

Accordingly, flux into which alcohol amine is added has been conventionally proposed (See patent document 1, for example).

### [DOCUMENT FOR PRIOR ART]

### [PATENT DOCUMENT]

Patent Document 1: Japanese Patent Application Publication No. 2002-59293. Additionally, US2001/019075, US 2003/221748 and US 2005/217757 each disclose solder fluxes.

### [SUMMARY OF THE INVENTION]

### [PROBLEM TO BE SOLVED BY THE INVENTION]

However, in the conventional flux, it is necessary to wash the flux residue because water solubility alcohol amine is added thereto as a main component.

The present invention is accomplished to resolve the problem and an object of the invention is to provide flux composition that is capable of removing an oxide film formed on a surface of aluminum and is unnecessary for washing the flux residue, liquid flux obtained by solving this flux composition by a solvent, resin flux cored solder wire in which flux composed of the flux composition is included in solder, and solder paste in which a thixotropic agent, a solvent and solder powder are added to the flux composition.

### [MEANS FOR SOLVING THE PROBLEMS]

The inventors of this application have found out components such that it is capable of removing the oxide film formed on the surface of aluminum and making the wash of the flux residue unnecessary by using water-insoluble resin as base material and adding amine and fluorine series activator as the flux composition thereto.

This invention relates to flux composition containing water-insoluble rosin of 65 through 94 mass% as base material, at least amine of 3 through 22 mass%, and amine fluoride salt as the fluorine series activator, which is formed by reacting amine and acid, of 1 through 30 mass%, and wherein the amine includes aromatic amine, a compound having a guanidine skeleton, and any one species of a pyridine derivative, an imidazole derivative, ethylamine and picoperine, and thereby removing an oxide film formed on a surface of aluminum to solder the aluminum.

Hence the amine includes an aromatic amine having an aromatic ring on a structure thereof, and includes a compound having a guanidine skeleton as the amine. It is preferable to contain ethylamine as the amine.

Hence the amine contains at least any one species of the aromatic amine, the compound having a guanidine skeleton and the ethylamine, which have been described above, and to contain at least any one species of a pyridine derivative, an imidazole derivative, a guanidine derivative, ethylamine and picoperine, as the amine.

The flux composition contains, as the amine fluoride salt, at least any one species of salt formed from an amine compound including any of the pyridine derivative, the imidazole derivative, the guanidine derivative, the ethylamine and the picoperine, and acid including any of hydrofluoric acid, fluoboric acid and hexafluorosilicic acid, or amine-borontrifluoride complex.

It is preferable to contain any of 4-benzilpyridine, 4-phenylpyridine, 4-(3-phenylpropyl)pyridine as the pyridine derivative, any of 1-benzil-2-phenylimidazole, 2-phenylimidazole, 1-benzil-2-methylimidazole, 2-ethyl-4-methylimidazole, 1,2-dimethylimidazole as the imidazole derivative and any of 1,3-diphenylguanidine, 1,3-di-o-tolylguanidine, 1-o-tolylbiguanide as the guanidine derivative.

The flux composition contains at least any one species of polymerized rosin, hydrogenated rosin and acid-modified rosin as the rosin.

Further, this invention relates to liquid flux obtained by solving the above-mentioned flux composition by a solvent, resin flux cored solder wire in which flux composed of this flux composition is included in solder, and solder paste in which a thixotropic agent, a solvent and solder powder are added to this flux composition.

### [EFFECT OF THE INVENTION]

According to the invention, by a combination of the amine and the amine fluoride salt in the flux composition, it is capable of removing an oxide film formed on a surface of aluminum. This allows the wettability to be improved at the soldering in the solder using the flux composed of the flux composition according to the invention and enables the solderability to be improved.

Further, since this invention uses water-insoluble resin as base material, it is possible to suppress moisture absorption into the flux residue and to suppress any corrosion of the soldered portion. Further, usage of the resin as the base material allows activator component such as the amine fluoride salt to be maintained in the flux residue with the component being trapped in the flux residue so that it is possible to suppress reaction of the soldered portion and the activator component.

The flux composition according to the invention, the liquid flux obtained by solving this flux composition by a solvent, the resin flux cored solder wire in which flux composed of this flux composition is included in solder, and the solder paste in which a thixotropic agent, a solvent and solder powder are added to the flux composition allow the wettability to be improved at the soldering and enable the solderability to be improved. Further, it is possible to suppress moisture absorption into the flux residue and to suppress any reaction of the activator component in the flux residue and the soldered portion to suppress the corrosion of the soldered portion. Thus, since the corrosion of the soldered portion by the flux residue is suppressed, their usage is allowable without washing the flux residue.

### [BRIEF DESCRIPTION OF DRAWINGS]

[FIG. 1] FIG. 1 is a graph showing a relationship between an additive amount of amine fluoride salt and wetting speed.
[FIG. 2] FIG. 2 is a graph showing a relationship between an additive amount of amine compound and wetting speed.

### [MODES FOR IMPLEMENTING THE INVENTION]

The flux composition according to this embodiment contains water-insoluble resin, which is fusible at a heating temperature at the soldering, as base material, amine compound and fluorine series activator. The fluorine series activator is preferably added as the salt thereof. The amine fluoride salt, which is formed by reacting the amine compound and any acid, is added. The liquid flux according this embodiment is composed by solving the flux composition according to the following embodiments by a solvent. The resin flux cored solder wire according to the embodiment is composed so that flux composed of the flux composition according to the following embodiments is included in linear solder. The solder paste according to this embodiment is composed so that a thixotropic agent, a solvent and solder powder are added to the flux composition according to the following embodiments.

The flux composition includes any components which cannot be decomposed and volatilized at a heating temperature in the soldering time and they remain as flux residue around the soldered portion after the soldering. When the flux residue has water-soluble component, in a soldered product such as electronic parts and a board, there is a risk such that the corrosion facilitates in the soldered portion and the like because of moisture absorption into the flux residue. Therefore, it is necessary to wash the flux residue when components becoming the flux residue are water-soluble.

For the flux composition according to this embodiment, in order to allow the soldered product to be used without washing the flux residue, the base material which is main component of the flux composition and becomes the residue is required to have water-insoluble component.

Further, the flux composition according to this embodiment is required to allow the activator component to be mixed thereinto, to present non-volatilizing at a heating temperature in a soldering time, and to have a heat-resisting property that can protect the activator component from heat and fusibility by which the activator component can contact metal to be soldered at the heating temperature in the soldering time.

Therefore, in the flux composition according to this embodiment, as the resin that is water-insoluble but is soluble in an organic solvent and is fusible at a heating temperature in the soldering time, rosin is used as the base material. As the rosin, any of the polymerized rosin, the hydrogenated rosin and the acid-modified rosin or their combination is preferable.

Regarding the flux composition according to this embodiment, the metal to be soldered is aluminum so that it is required to remove an oxide film formed on the surface of aluminum. In order to remove aluminum hydroxide (AlOOH) and aluminum oxide (Al₂O₃; alumina) which are the oxide film formed on the surface of the aluminum, the amine compound and the amine fluoride salt are added to the flux composition according to the invention.

The reaction of aluminum hydroxide (AlOOH), which is the oxide film formed on the surface of the aluminum, facilitates under an environment in which a hydrogen ion exponent (pH) is high.

By adding the amine compound into the flux composition according to this embodiment, the reaction of the oxide film on the aluminum facilitates by basic of the amine compound in the soldering time so that a product (AlOO⁻) formed on the oxide film and a component of the amine compound are reacted to prevent a formation of the oxide film.

In this embodiment, as the amine compound to be added to the flux composition, it is desirable to have basic that allows the reaction of the oxide film on the aluminum to facilitate and to have low corrosive property because there is a possibility of remaining in the residue and high insulation reliability. Preferably, it is ethylamine, an aromatic amine having an aromatic ring on a structure thereof, or an amine compound having a guanidine skeleton.

As such an amine compound, it is preferable to contain any of a pyridine derivative, an imidazole derivative, a guanidine derivative and picoperine.

As the pyridine derivative, it is preferable to contain any of 4-benzilpyridine, 4-phenylpyridine and 4-(3-phenylpropyl)pyridine.

It is preferable that the imidazole derivative contains 1-benzil-2-phenylimidazole, 2-phenylimidazole, 1-benzil-2-methylimidazole, 2-ethyl-4-methylimidazole and/or 1,2-dimethylimidazole.

As the guanidine derivative, it is also preferable to contain any of 1, 3-diphenylguanidine, 1, 3-di-o-tolylguanidine and 1-o-tolylbiguanide.

In the aluminum oxide (Al₂O₃) which is the oxide film formed on the surface of the aluminum, fluorine ion (F⁻) generates a crack through which the aluminum is exposed so that it is in a state where the reaction thereof facilitates.

In the flux composition according to this embodiment, by adding the amine fluoride salt, fluorine (F) constituting the amine fluoride salt is ionized. The fluorine ion (F⁻) allows any cracks to be generated in the oxide film of aluminum and the aluminum is exposed from the oxide film through the cracks so that the reaction thereof facilitates and the oxide film peels off.

In this embodiment, as the amine fluoride salt to be added to the flux composition, it is preferable to contain at least any one species of salt formed from the above-mentioned amine including any of the pyridine derivative, the imidazole derivative, the guanidine derivative, the ethylamine and the picoperine, and acid including any of hydrofluoric acid (HF), fluoboric acid (HBF4) and hexafluorosilicic acid, or amine-borontrifluoride complex.

The amine fluoride salt to be added to the flux composition may be configured so that the previously produced one is mixed to the rosin. Further, it may be configured so that any of the above-mentioned amine compound and acid or a combination of them is mixed to the rosin and the amine fluoride salt is produced by the reaction in the base material.

### [EMBODIMENTS]

They prepared flux of the embodiments and the comparison examples as indicated in the following respective tables and reviewed solderability, corrosive property and wettability thereof. In the embodiments and the comparison examples, liquid flux obtained by solving the flux composition was used. It is to be noted that a percentage of the composition in each engagement is mass% of the flux composition. First, the following will describe an evaluation method of each review and conditions thereof.

### (1) Review of Solderability

### (a) Evaluation Method:

They mounted ring-shaped solder on an aluminum plate, applied flux thereto and then, heated to melt the solder and to confirm the wettability thereof.

### (b) Evaluation Conditions:

Test Piece; Aluminum Plate (A1050)
Size of Test Piece; Length of 30 mm, Width of 5 mm and Thickness of 0.3 mm
An amount of Flux Application; 0.05 ml
Solder; Sn-3.0Ag-0.5Cu
Soldering Temperature; 300 °C

### (c) Decision Standards

Double Circle Mark; Well soldered
Single Circle Mark; Small soldered but being wet and spread-out
Triangle Mark; Soldered but being not spread-out
Cross Mark; Not soldered

### (2) Review of Corrosive Property

### (a) Evaluation Method:

They left each of the soldered test pieces as it is for 63 hours in an environment of the temperature of 40 °C and humidity of 90% and confirmed the corrosive property thereof after the soldering.

### (b) Decision Standards

Double Circle Mark; No corrosion was seen
Single Circle Mark; Corrosion was partially seen
Triangle Mark; Corrosion was seen
Cross Mark; Corrosion was widely seen
Dash mark; Non-execution

### (3) Wetting Speed of Solder

### (a) Evaluation Method:

They immersed and applied the flux to the aluminum plates and measured a period of wetting time for the solder using a meniscograph method.

### (b) Evaluation Conditions

Test apparatus; Solder checker SAT-5200 manufactured by RHESCA
Solder; Sn-15Zn-0.03Ti-0.03Al
Aluminum Plate; A1050
Size of Test Piece; Length of 30 mm, Width of 5 mm and Thickness of 0.3 mm
Soldering Temperature; 300 °C
Immersing speed; 20 min/sec
Depth of immersion; 3 mm
Period of immersing time; 10 sec

### 1. Review of Activator Component

They prepared the flux of the embodiments and the comparison examples based on the composition as indicated in Table 1 to order to review the solderability and the corrosive property by the activator component and reviewed the solderability and the corrosive property by the evaluation methods and the evaluation conditions, which were indicated by the above-mentioned items (1) and (2). In the flux composition indicated in Table 1, they used the amine fluoride salt composed of the amine compound and the fluorine series activator as the embodiments and they used the salt composed of the amine compound and bromine series activator or chlorine series activator as the comparison examples. Further, they used the pyridine derivative as the amine and the rosin as the resin.

**[TABLE 1]**

| | EMBODIMENTS | | | | | | | | COMPARISON EXAMPLES | | | |
|---|---|---|---|---|---|---|---|---|---|---|---|---|
| | 1 | 2 | 3 | 4 | 5 | 6 | 7 | 8 | 1 | 2 | 3 | 4 |
| DPhG·HBF₄ | 1 | 3 | 5 | 8 | 12.5 | 30 | | | | | | |
| ETHYLAMINE·HF | | | | | | | 12.5 | | | | | |
| PIPERIDINE· BF3 | | | | | | | | 12.5 | | | | |
| DPhG·HBr | | | | | | | | | 12.5 | | | |
| DPhG·HCl | | | | | | | | | | 12.5 | | |
| ETHYLAMINE·HBr | | | | | | | | | | | 12.5 | |
| ETHYLAMINE·HCl | | | | | | | | | | | | 12.5 |
| PYRIDINE DERIVATIVE | 3 | 14 | 13.5 | 13 | 12.5 | 10 | 12.5 | 12.5 | 12.5 | 12.5 | 12.5 | 12.5 |
| ROSIN | BALANCE | BALANCE | BALANCE | BALANCE | BALANCE | BALANCE | BALANCE | BALANCE | BALANCE | BALANCE | BALANCE | BALANCE |
| SOLDERABILITY | Δ | ○ | ⊚ | ⊚ | ⊚ | ⊚ | ⊚ | ⊚ | × | × | × | × |
| CORROSIVE PROPERTY | ⊚ | ⊚ | ⊚ | ⊚ | ⊚ | ○ | Δ | ⊚ | - | - | - | - |

From the results of Table 1, they have found out that the flux of the embodiments in which the amine fluoride salt composed of the amine compound and the fluorine series activator is added thereto as the activator component presents good solderability. Additionally, they have also found out that the flux of the embodiments prevents the corrosion after the soldering. On the other hand, they have found out that the flux of the comparison examples in which the salt composed of the amine compound and the bromine series activator or the chlorine series activator is added thereto as the activator component presents no soldering in any examples, which results in a very bad solderability.

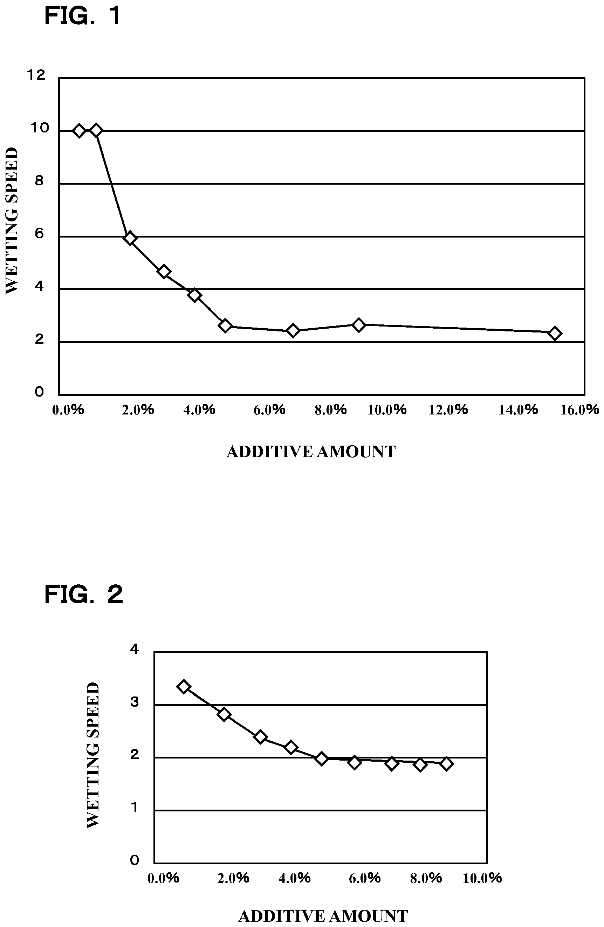

Here, they have found out, from the results of Table 1, that there is a difference in the solderability based on the additive amount of the amine fluoride salt which is an activator component. Accordingly, they showed the relationship between the additive amount of the amine fluoride salt and the wetting speed by the evaluation method and the evaluation conditions indicated in the above-mentioned item (3) in the Fig. 1. FIG. 1 is the graph showing the relationship between the additive amount of the amine fluoride salt and wetting speed. FIG. 1 shows a result obtained by reviewing, as the amine fluoride salt, the salt obtained by reacting diphenylguanidine with fluoboric acid (HBF4).

As shown in FIG. 1, they have found out that when the additive amount of the amine fluoride salt is 1 % or more, the wetting speed of the solder increases but when the additive amount thereof is 4 % or more, the wetting speed does not widely change to obtain a desired wetting speed. Therefore, they have found out that it is preferable that the additive amount of the amine fluoride salt in the flux is 1% or more. Here, an upper limit of the additive amount of the amine fluoride salt is determined by considering additive amount of other components.

### 2. Review of Amine Compound

They prepared the flux of the embodiments and the comparison examples based on the composition as indicated in Table 2 to order to review the solderability and the corrosive property by the amine compound and reviewed the solderability and the corrosive property by the evaluation methods and the evaluation conditions, which were indicated by the above-mentioned items (1) and (2).

**[TABLE 2]**

| | EMBODIMENTS | | | | | | | | | COMPARISON EXAMPLES | | |
|---|---|---|---|---|---|---|---|---|---|---|---|---|
| | 1 | 2 | 3 | 4 | 5 | 6 | 7 | 8 | 9 | 1 | 2 | 3 |
| AMINE FLUORIDE SALT | 14 | 13.5 | 13 | 12.5 | 11 | 12.5 | 12.5 | 12.5 | 12.5 | 12.5 | 12.5 | 12.5 |
| PYRIDINE DERIVATIVE | 3 | 5 | 8 | 12.5 | 22 | | | | | | | |
| IMIDAZOLE DERIVATIVE | | | | | | 12.5 | | | | | | |
| GUANIDINE DEVIVATIVE | | | | | | | 12.5 | | | | | |
| ETHYLAMINE | | | | | | | | 125 | | | | |
| PICOPERIN | | | | | | | | | 12.5 | | | |
| 2-AMINOPROPIONIC ACID | | | | | | | | | | 12.5 | | |
| AMMONIUM ADIPATE | | | | | | | | | | | 12.5 | |
| STEARIC ACID AMIDE | | | | | | | | | | | | 12.5 |
| ROSIN | BALANCE | BALANCE | BALANCE | BALANCE | BALANCE | BALANCE | BALANCE | BALANCE | BALANCE | BALANCE | BALANCE | BALANCE |
| SOLDERABILITY | ○ | ⊚ | ⊚ | ⊚ | ⊚ | ⊚ | ⊚ | ⊚ | ⊚ | × | × | × |
| CORROSIVE PROPERTY | ⊚ | ⊚ | ⊚ | ⊚ | ○ | ⊚ | ⊚ | ○ | ○ | - | - | - |

From the results of Table 2, they have found out that the flux of the embodiments into which any of the pyridine derivative, the imidazole derivative, the guanidine derivative, the ethylamine and the picoperine is added as the amine compound presents good solderability. Additionally, they have also found out that the flux of the embodiments prevents the corrosion after the soldering. On the other hand, they have found out that the flux of the comparison examples into which any of 2-aminopropionic acid, ammonium adipate, and stearic acid amide is added presents no soldering in any examples, which results in a very bad solderability.

Here, they have found out, from the results of Table 2, that there is a difference in the solderability based on the additive amount of the amine compound. Accordingly, they showed the relationship between the additive amount of the amine compound and the wetting speed by the evaluation method and the evaluation conditions indicated in the above-mentioned item (3) in the FIG. 2. FIG. 2 is the graph showing the relationship between the additive amount of the amine compound and wetting speed. FIG. 2 shows a result obtained by reviewing, as the amine compound, the 4-benzilpyridine which is the pyridine derivative.

As shown in FIG. 2, they have found out that when the additive amount of the 4-benzilpyridine is 3 % or more, a desired wetting speed is obtained. Therefore, they have found out that it is preferable that the additive amount of the amine compound in the flux is 3 % or more. Here, an upper limit of the additive amount of the amine compound is determined by considering additive amount of other components.

### 3. Review of Solderability and Corrosive Property by Resin-base Flux and Water Soluble Flux

They prepared the flux of the embodiments and the comparison examples based on the composition as indicated in Table 3 to order to review the solderability and the corrosive property of the resin-base flux and the water-soluble flux and reviewed the solderability and the corrosive property by the evaluation methods and the evaluation conditions, which were indicated by the above-mentioned items (1) and (2). In the flux composition indicated in Table 3, they used the flux, as the embodiments, in which the rosin as the water-insoluble resin was base material and to which the amine compound and the amine fluoride salt were added. On the other hand, they used the flux, as the comparison examples, in which water solubility triethanolamine was base material and to which fluoboric metal salt is added.

**[TABLE 3]**

| | EMBODIMENTS | | | COMPARISON EXAMPLES | | | |
|---|---|---|---|---|---|---|---|
| | 1 | 2 | 3 | 1 | 2 | 3 | 4 |
| AMINE FLUORIDE SALT | 12.5 | 12.5 | 12.5 | | | | |
| PYRIDINE DERIVATIVE | 12.5 | | | | | | |
| IMIDAZOLE DERIVATIVE | | 12.5 | | | | | |
| GUANIDINE DEVIVATIVE | | | 12.5 | | | | |
| ETHYLAMINE | | | | | | | |
| ROSIN | BALANCE | BALANCE | BALANCE | | | | |
| FLUOBORIC ACID | | | | | | | 10 |
| FLUOBORIC ZINC | | | | 10 | | 3 | |
| FLUOBORIC CADMIUM | | | | | 10 | 10 | 7 |
| FLUOBORIC AMMONIUM | | | | 8 | | | |
| FLUOBORIC AMMONIA | | | | | 8 | 5 | |
| TRIETHANOLAMINE | | | | 82 | 82 | 82 | 83 |
| SOLDERABILITY | ⊚ | ⊚ | ⊚ | ⊚ | ⊚ | ⊚ | ⊚ |
| CORROSIVE PROPERTY | ⊚ | ⊚ | ⊚ | × | × | × | × |

From the results of Table 3, they have found out that the flux of all of the embodiments in which the rosin is base material and into which the amine compound and the amine fluoride is added presents good solderability. Additionally, they have also found out that the flux of the embodiments prevents the corrosion after the soldering. On the other hand, they have found out that the flux of the comparison examples in which the triethanolamine is base material and to which the fluoboric metal salt is added presents any soldering but have found out that the corrosion facilitates.

### 4. Review Results

The rosin which is the base material of the flux composition has been necessary to be of about 65 % of the flux composition in order to maintain the amine and the amine fluoride salt. Accordingly, they have found out that the additive amount of the rosin is preferably of 65 through 94 % of the flux composition.

Further, a lower limit of the additive amount of the amine compound is preferably 3 % or more, which has been described above. They have found out that when determining the upper limit of the additive amount of amine compound taking into consideration the additive amount of other components such as the rosin and the amine fluoride, the additive amount of the amine compound is preferably of 3 through 22 % of the flux composition.

Additionally, a lower limit of the additive amount of the amine fluoride salt is preferably 1 % or more, which has been described above. They have found out that when determining the upper limit of the additive amount of the amine fluoride salt taking into consideration the additive amount of other components such as the rosin and the amine compound, the additive amount of the amine fluoride salt is preferably of 1 through 30 % of the flux composition.

### [INDUSTRIAL AVAILABILITY]

The present invention is preferably applicable to flux which is used for soldering aluminum (Al) and has such excellent solderability and corrosion resistance that cannot be obtained by flux used for a case where the metal to be soldered is copper (Cu) or the like.

Although the liquid flux obtained by solving the flux composition according to the invention by a solvent has been described as the embodiments of the invention, the present invention is also applicable to the resin flux cored solder wire in which the flux composed of the flux composition according to the invention is included in the solder, and the solder paste in which a thixotropic agent, a solvent and solder powder are added to the flux composition according to the invention.

## Claims

1. Flux composition adapted for soldering aluminum, the flux composition removing aluminum hydroxide and aluminum oxide formed on a surface of the aluminum, being unnecessary for washing flux residue, the flux composition comprising:
water-insoluble rosin of 65 through 94 mass% as base material,
at least amine of 3 through 22 mass%, and
amine fluoride salt of 1 through 30 mass%, the amine fluoride salt being formed by reacting amine with acid, and wherein
the amine includes aromatic amine having an aromatic ring on a structure thereof, a compound having a guanidine skeleton, and any one species of a pyridine derivative, an imidazole derivative, ethylamine and picoperine, wherein the flux composition contains, as the amine fluoride salt, at least one species of salt formed from an amine compound including any of the pyridine derivative, the imidazole derivative, the guanidine derivative, the ethylamine and the picoperine, and acid including any of hydrofluoric acid, fluoboric acid and hexafluorosilicic acid, or amine-borontrifluoride complex, wherein the flux composition contains at least any one species of polymerized rosin, hydrogenated rosin and acid-modified rosin as the rosin.

2. The flux composition according to Claim 1 **characterized in that** the flux composition contains:
any of 4-benzilpyridine, 4-phenylpyridine, 4-(3-phenylpropyl)pyridine as the pyridine derivative;
any of 1-benzil-2-phenylimidazole, 2-phenylimidazole, 1-benzil-2-methylimidazole, 2-ethyl-4-methylimidazole, 1,2-dimethylimidazole as the imidazole derivative; and
any of 1,3-diphenylguanidine, 1,3-di-o-tolylguanidine, 1-o-tolylbiguanide as the guanidine derivative.

3. Liquid flux **characterized in that** the liquid flux is obtained by dissolving the flux composition according to any one of Claims 1 through 4 by a solvent.

4. Resin flux cored solder wire **characterized in that** the flux composed of the flux composition according to any one of Claims 1 through 4 is included in solder.

5. Solder paste **characterized in that** a thixotropic agent, a solvent and solder powder are added to the flux composition according to any one of Claims 1 through 4.

## Patentansprüche

1. Flussmittelzusammensetzung, ausgelegt zum Löten von Aluminium, wobei die Flussmittelzusammensetzung auf einer Oberfläche des Aluminiums gebildetes Aluminiumhydroxid und Aluminiumoxid entfernt, wobei Waschen von Flussmittelrückstand unnötig ist, wobei die Flussmittelzusammensetzung umfasst:
wasserunlösliches Kolophonium mit 65 bis 94 Masse-% als Grundmaterial,
wenigstens Amin mit 3 bis 22 Masse-% und
Aminfluoridsalz mit 1 bis 30 Masse-%, wobei das Aminfluoridsalz durch Umsetzen von Amin mit Säure gebildet ist und wobei das Amin aromatisches Amin mit einem aromatischen Ring an einer Struktur davon, eine Verbindung mit einem Guanidinskelett und eine beliebige Spezies von einem Pyridinderivat, einem Imidazolderivat, Ethylamin und Picoperin einschließt, wobei
die Flussmittelzusammensetzung als das Aminfluoridsalz wenigstens eine Spezies von Salz, die aus einer Aminverbindung, einschließlich eines beliebigen von dem Pyridinderivat, dem Imidazolderivat, dem Guanidinderivat, dem Ethylamin und dem Picoperin, und einer Säure, einschließlich einer beliebigen von Fluorwasserstoffsäure, Borwasserstoffsäure und Hexafluorkieselsäure, gebildet ist, oder Amin-Bortrifluorid-Komplex enthält, wobei die Flussmittelzusammensetzung wenigstens eine Spezies von polymerisiertem Kolophonium, hydriertem Kolophonium und säuremodifiziertem Kolophonium als das Kolophonium enthält.

2. Flussmittelzusammensetzung gemäß Anspruch 1, **dadurch gekennzeichnet, dass** die Flussmittelzusammensetzung enthält:
ein beliebiges von 4-Benzylpyrdin, 4-Phenylpyridin, 4-(3-Phenylpropyl)pyridin als das Pyridinderivat;
ein beliebiges von 1-Benzyl-2-phenylimidazol, 2-Phenylimidazol, 1-Benzyl-2-methylimidazol, 2-Ethyl-4-methylimidazol, 1,2-Dimethylimidazol als das Imidazolderivat; und
ein beliebiges von 1,3-Diphenylguanidin, 1,3-Di-o-tolylguanidin, 1-o-Tolylbiguanid als das Guanidinderivat.

3. Flüssiges Flussmittel, **dadurch gekennzeichnet, dass** das flüssige Flussmittel durch Lösen der Flussmittelzusammensetzung gemäß einem der Ansprüche 1 bis 4 durch ein Lösungsmittel erhalten ist.

4. Lötmittel mit einem Kolophoniumflussmittelkern, **dadurch gekennzeichnet, dass** das Flussmittel, das aus der Flussmittelzusammensetzung gemäß einem der Ansprüche 1 bis 4 besteht, in Lötmittel enthalten ist.

5. Lötmittelpaste, **dadurch gekennzeichnet, dass** ein thixotropes Mittel, ein Lösungsmittel und Lötmittelpulver zu der Flussmittelzusammensetzung gemäß einem der Ansprüche 1 bis 4 zugegeben sind.

## Revendications

1. Composition de flux adaptée au brasage tendre de l'aluminium, la composition de flux retirant l'hydroxyde d'aluminium et l'oxyde d'aluminium formés sur une surface de l'aluminium, le lavage du résidu de flux étant inutile, la composition de flux comprenant :
une colophane insoluble dans l'eau pour 65 à 94 % en masse comme matériau de base,
au moins une amine pour 3 à 22 % en masse, et
un sel de fluorure d'amine pour 1 à 30 % en masse, le sel de fluorure d'amine étant formé en faisant réagir une amine avec un acide, et dans laquelle
l'amine comporte une amine aromatique ayant un cycle aromatique sur une structure de celle-ci, un composé ayant un squelette guanidine, et n'importe quelle espèce parmi un dérivé de pyridine, un dérivé d'imidazole, l'éthylamine et la picopérine,
la composition de flux contenant, comme sel de fluorure d'amine, au moins une espèce de sel formée à partir d'un composé amine comportant n'importe quelle espèce parmi le dérivé de pyridine, le dérivé d'imidazole, l'éthylamine et la picopérine, et un acide comportant n'importe quel acide parmi l'acide fluorhydrique, l'acide fluoborique et l'acide hexafluorosilicique, ou un complexe amine-fluorure de bore, la composition de flux contenant au moins n'importe quelle espèce parmi la colophane polymérisée, la colophane hydrogénée et la colophane modifiée par acide comme colophane.

2. Composition de flux selon la revendication 1 **caractérisée en ce que** la composition de flux contient :
n'importe quelle espèce parmi la 4-benzylpyridine, la 4-phénylpyridine, la 4-(3-phénylpropyl)pyridine comme dérivé de pyridine ;
n'importe quelle espèce parmi le 1-benzyl-2-phénylimidazole, le 2-phénylimidazole, le 1-benzyl-2-méthyl-imidazole, le 2-éthyl-4-méthylimidazole, le 1,2-diméthylimidazole comme dérivé d'imidazole ; et
n'importe quelle espèce parmi la 1,3-diphényl-guanidine, la 1,3-di-o-tolylguanidine, le 1-o-tolylbiguanide comme dérivé de guanidine.

3. Flux liquide **caractérisé en ce que** le flux liquide est obtenu en dissolvant la composition de flux selon l'une quelconque des revendications 1 à 4 avec un solvant.

4. Fil de brasage tendre avec âme en flux résineux **caractérisé en ce que** le flux composé de la composition de flux selon l'une quelconque des revendications 1 à 4 est contenu dans la brasure tendre.

5. Pâte de brasage tendre **caractérisée en ce qu'**un agent thixotrope, un solvant et une poudre de brasage tendre sont ajoutés à la composition de flux selon l'une quelconque des revendications 1 à 4.
